# EUROPEAN PATENT APPLICATION

(11) **EP 4 528 793 A1**
(43) Date of publication of application: **26.03.2025**
(21) Application number: 22942598.8
(22) Date of filing: 16.05.2022
(51) Int. Cl.: H01L 21/60, H01L 21/52

(54) **BONDING APPARATUS, BONDING METHOD, AND BONDING CONTROL PROGRAM**

(71) Applicant: Shinkawa Ltd., Tokyo 208-8585 (JP)
(72) Inventor: FUKUMOTO, Shinsuke, Musashimurayama-shi, Tokyo 208-8585 (JP); NOMURA, Katsutoshi, Musashimurayama-shi, Tokyo 208-8585 (JP)
(74) Representative: Becker, Eberhard
(86) International application number: PCT/JP2022/020416
(87) International publication number: WO 2023/223393

(57) **Abstract**

A bonding apparatus 1 comprises: a bonding head 2 including a pressure tool PT that pressurizes an electronic component 9 and a heater 22 that heats the pressure tool PT, the pressure tool PT being configured so as to be detachable from the heater 22; a storage unit 5 that stores temperature control data indicating temporal changes in the set temperature of the heater 22; and a control unit 4 that controls the set temperature of the heater 22 on the basis of the temperature control data. The temperature control data has one or more temperature control patterns associated with bonding conditions for bonding the electronic component 9 to a substrate 8. The control unit 4 reads one of the one or more temperature control patterns according to the bonding conditions and controls the set temperature of the heater 22.

## Description

### Technical Field

The present invention relates to a bonding apparatus, a bonding method, and a bonding control program.

### Related Art

In terms of techniques for bonding an electronic component onto a substrate, it is important to control the temperature at the tip of the bonding head according to the bonding conditions when bonding the electronic component mounted on the substrate. This is because the temperature control of the bonding head during bonding differs depending on the bonding conditions when mounting an electronic component on a substrate, such as the thickness of the electronic component, the type of the electrode or bonding material, and the orientation of the electronic component (for example, whether the front surface on which an integrated circuit pattern is formed faces the substrate). At this time, the solder or adhesive material between the electronic component and the substrate is melted, and then the bonding head is cooled so that the solder or adhesive is also cooled and fixed, thereby completing the joining between the electronic component and the substrate. For example, Patent Document 1 discloses a bonding apparatus having a cooling structure that controls the temperature at the tip of the bonding head when pressing a substrate to an electronic component.

### Citation List

### Patent Document

[Patent Document 1] Japanese Patent Application Laid-Open No. 2016-149567

### SUMMARY OF INVENTION

### Technical Problem

However, the technique described in Patent Document 1 cannot perform high-precision bonding associated with the bonding conditions of the electronic component to be mounted on the substrate.

Thus, an object of the present invention is to provide a bonding apparatus, a bonding method, and a bonding control program that enable high-precision bonding associated with the bonding conditions of the electronic component.

### Solution to Problem

A bonding apparatus according to the first aspect of the present invention is a bonding apparatus for bonding an electronic component to a substrate. The bonding apparatus includes: a bonding head including a pressure tool that pressurizes the electronic component and a heater that heats the pressure tool, in which the pressure tool is configured to be attachable to and detachable from the heater; a storage part storing temperature control data that indicates a temporal change in a set temperature of the heater; and a controller controlling the set temperature of the heater based on the temperature control data, in which the temperature control data has one or more temperature control patterns associated with bonding conditions for bonding the electronic component to the substrate, and the controller reads out one temperature control pattern of the one or more temperature control patterns according to the bonding conditions, and controls the set temperature of the heater.

Further, a bonding method according to the second aspect of the present invention includes: preparing a bonding head including a pressure tool that pressurizes an electronic component and a heater that heats the pressure tool, in which the pressure tool is configured to be attachable to and detachable from the heater; pressurizing the electronic component toward a substrate with the pressure tool; and reading out temperature control data that indicates a temporal change in a set temperature of the heater from a storage part, and controlling the set temperature of the heater based on the temperature control data by a controller, in which the temperature control data has one or more temperature control patterns associated with bonding conditions for bonding the electronic component to the substrate, and controlling the set temperature of the heater includes reading out one temperature control pattern of the one or more temperature control patterns according to the bonding conditions, and controlling the set temperature of the heater.

Further, a bonding control program according to the third aspect of the present invention is a bonding control program for controlling a bonding apparatus which includes: a bonding head including a pressure tool that pressurizes an electronic component and a heater that heats the pressure tool, in which the pressure tool is configured to be attachable to and detachable from the heater; a storage part storing temperature control data that indicates a temporal change in a set temperature of the heater; and a controller controlling the set temperature of the heater based on the temperature control data, in which the temperature control data has one or more temperature control patterns associated with bonding conditions for bonding the electronic component to the substrate, and the bonding control program causing a computer of the controller to: read out one temperature control pattern of the one or more temperature control patterns according to the bonding conditions; and control the set temperature of the heater based on the read temperature control pattern.

### Effects of Invention

According to the present invention, it is possible to provide a bonding apparatus, a bonding method, and a bonding control program that enable high-precision bonding associated with the bonding conditions.

### BRIEF DESCRIPTION OF DRAWINGS

FIG. 1 is a diagram showing an example of the configuration of the bonding apparatus 1 according to an embodiment of the present disclosure.
FIG. 2 is a diagram showing an example of the configuration of the bonding apparatus 1 according to an embodiment of the present disclosure.
FIG. 3 is a flow chart showing the heater temperature control method according to an exemplary embodiment.
FIG. 4 is a flow chart showing the bonding according to an exemplary embodiment.
FIG. 5A is a diagram showing the temperature control signal output to the heater according to an exemplary embodiment.
FIG. 5B is a diagram showing an example of comparison between the process window and the measurement pattern according to an exemplary embodiment.
FIG. 6A is a diagram showing the temperature control signal output to the heater according to another exemplary embodiment.
FIG. 6B is a diagram showing an example of comparison between the process window and the measurement pattern according to another exemplary embodiment.

### DESCRIPTION OF EMBODIMENTS

The present invention will be described hereinafter through embodiments of the invention, but the invention according to the claims is not limited to the following embodiments. Furthermore, not all the configurations described in the embodiments are necessarily essential means for solving the problems.

### <Configuration example of the bonding apparatus>

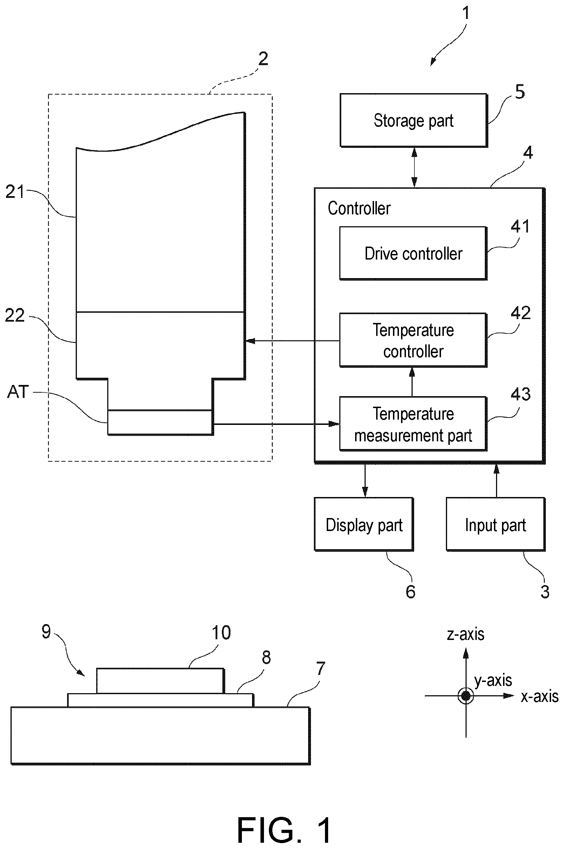

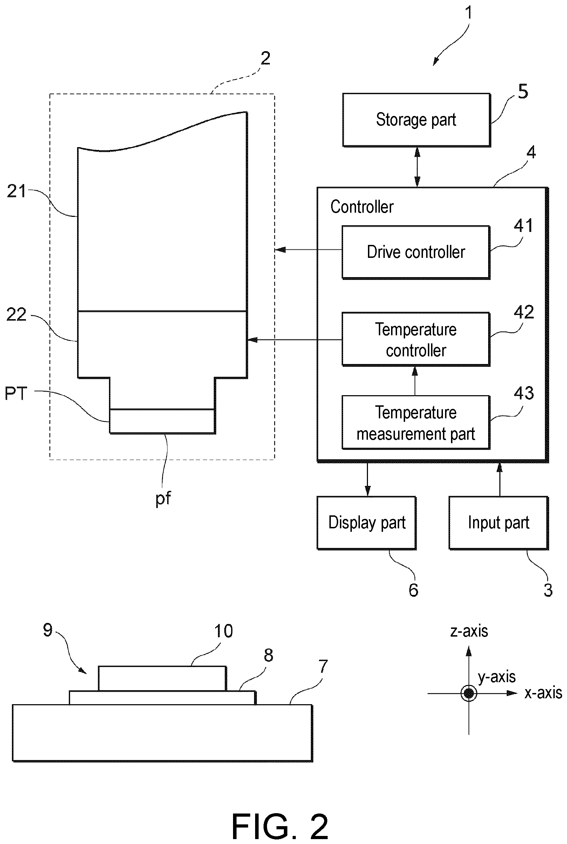

A configuration example of the bonding apparatus will be described below with reference to FIG. 1 and FIG. 2. FIG. 1 and FIG. 2 are diagrams showing an example of the configuration of a bonding apparatus 1 according to an embodiment of the present disclosure.

In the bonding apparatus 1 according to one aspect of the present invention, as shown in FIG. 1, the temperature of a heater 22 is adjusted in advance in association with the bonding conditions (for example, the type of an electronic component 9), and as shown in FIG. 2, bonding of the electronic component 9 to a substrate 8 is performed. The electronic component 9 is, for example, a semiconductor die. In this case, the semiconductor die has a certain thickness, and has a front surface on which an integrated circuit pattern is formed, and a back surface opposite the front surface. Semiconductor dies differ in external dimensions, thickness, electrode configuration, etc. depending on the types, and the temperature change and pressure change required for bonding also differ. Therefore, in order to achieve suitable bonding, it is necessary to perform temperature adjustment and bonding associated with the bonding conditions. With the bonding apparatus 1 described below, it is possible to provide a bonding apparatus 1 that enables high-precision bonding corresponding to the type of the electronic component 9 to be mounted on the substrate 8, for example.

The bonding apparatus 1 according to the present disclosure includes a bonding head 2, an input part 3, a controller 4, a storage part 5, and a display part 6.

The bonding head 2 is composed of an actuator 21, a heater 22, and an adjustment tool AT or a pressure tool PT. The bonding head 2 can be moved in a z-axis direction (up-down direction in FIG. 1 and FIG. 2) and rotated around the z-axis. Further, the bonding head 2 may be attached to an XY mechanism that moves the bonding head 2 in two axes, an x-axis direction (left-right direction in FIG. 1) and a y-axis direction (front-depth direction in FIG. 1 and FIG. 2) (not shown), and may also be rotated on each axis or swiveled around each axis.

The actuator 21 moves the bonding head 2 in the z-axis direction. As shown in FIG. 1 and FIG. 2, the heater 22 and the adjustment tool AT or the pressure tool PT are attached to the actuator 21, making it possible to drive the entire bonding head 2.

The heater 22 is raised or lowered in temperature based on the temperature control from the controller 4 to heat or dissipate heat to the adjustment tool AT or the pressure tool PT. The adjustment tool AT or the pressure tool PT is configured to be attached to and detachable from the tip of the heater 22. The heater 22 is raised or lowered in temperature upon receiving a temperature control signal from the controller 4. The heater 22 may include a heater circuit, and for example, the heater 22 may be heated by receiving the temperature control signal with the heater circuit, or cooled by dissipating heat into the atmosphere. The heater 22 may be attached to the actuator 21 via a heat insulating material.

The adjustment tool AT is heated or cooled by the heater 22. The adjustment tool AT may have a built-in temperature sensor, and for example, the temperature of the adjustment tool AT is measured by the temperature sensor. The temperature sensor (not shown) may also be separately provided on the surface of the adjustment tool AT. Furthermore, since the method of heating or applying pressure differs depending on the type of the electronic component 9, a plurality of types of adjustment tools AT are prepared for each electronic component 9. That is, the temperature control associated with the type of the electronic component 9 is performed using an adjustment tool AT selected from the plurality of types of adjustment tools AT. In addition, in the case where common temperature control can be performed for each of a plurality of types of electronic components 9, a common adjustment tool AT may be used, or different adjustment tools AT may be used for each type.

The pressure tool PT is heated or cooled by the heater 22. The pressure tool PT bonds the electronic component 9 to the substrate 8 in association with the drive of the bonding head 2. For example, the pressure tool PT has a pressing surface pf, and the pressing surface pf performs pressurization and heating for a predetermined time in a state of pressing a main surface 10 of the electronic component 9. Furthermore, since the method of heating or applying pressure differs depending on the type of the electronic component 9, a plurality of types of pressure tools PT are prepared for each electronic component 9. That is, the temperature control and pressure control associated with the type of the electronic component 9 are performed using a pressure tool PT selected from the plurality of types of pressure tools PT. In addition, in the case where common temperature control can be performed for each of a plurality of types of electronic components 9, a common pressure tool PT may be used, or different pressure tools PT may be used for each type.

The input part 3 generates various types of input information in response to an input operation of a user, and transmits the generated input information to the controller 4. The input part 3 generates, for example, information for driving the bonding head 2 and information for controlling the temperature of the heater 22. Further, the input part 3 receives an input operation of data from the user, and may include, for example, various buttons, a mouse, a keyboard, and a touch panel.

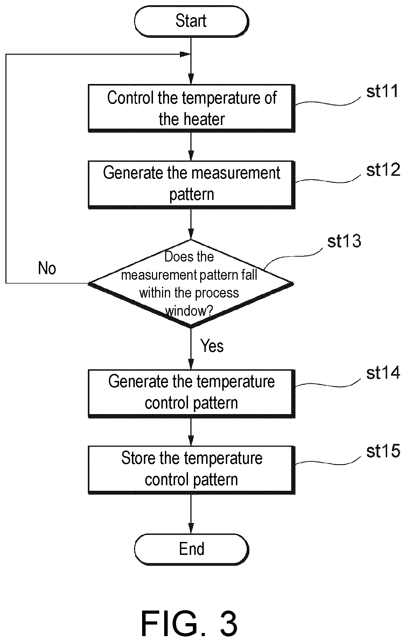

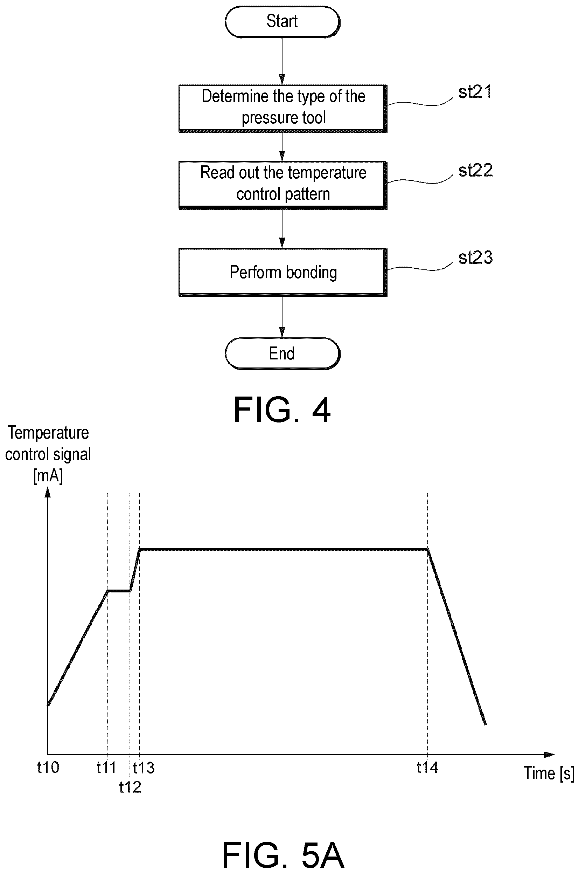

The controller 4 controls the bonding head 2. In addition, the controller 4 is connected to the input part 3, the storage part 5, and the display part 6 so as to be able to communicate with the input part 3, the storage part 5, and the display part 6. The controller 4 performs different operation flows when adjusting the heater temperature and when performing bonding. The details of each flow will be described later with reference to FIG. 3 and FIG. 4. The controller 4 includes a drive controller 41, a temperature controller 42, and a temperature measurement part 43.

The drive controller 41 controls the overall drive of the bonding head 2, such as the movement, position, and orientation. The drive controller 41, for example, drives the bonding head 2 to move up and down when bonding is performed.

The temperature controller 42 controls the temperature of the heater 22 and generates a temperature control pattern which will be described later. When adjusting the heater temperature, the temperature controller 42 compares a process window acquired from the storage part 5 with a measurement pattern acquired from the temperature measurement part 43 to generate the temperature control pattern. At this time, the measurement pattern acquired from the temperature measurement part 43 is a feedback value obtained from the adjustment tool AT by the temperature controller 42 controlling the temperature of the heater 22. The generated temperature control pattern is stored in the storage part 5, and when bonding is performed, the temperature controller 42 acquires the temperature control pattern from the storage part 5 and controls the temperature of the heater 22 based on this.

The temperature measurement part 43 generates the measurement pattern from the adjustment tool AT. The measurement pattern is a feedback value obtained from the adjustment tool AT by the temperature controller 42 controlling the temperature of the heater 22 as described above, and may be, for example, data of a temperature change of the adjustment tool AT in a predetermined time. The temperature measurement part 43 supplies the generated measurement pattern to the temperature controller 42.

The storage part 5 stores a plurality of process windows and one or more temperature control patterns. The plurality of process windows are data associated with each of the plurality of types of electronic components 9 stored in advance in the storage part 5, and may be, for example, a plurality of pieces of data in which a time range and a temperature range are determined. Further, the one or more temperature control patterns are data generated by the temperature controller 42 for each of the plurality of types of electronic components 9.

The display part 6 receives information obtained based on various types of input information input through the input part 3 from the controller 4 and displays the information. The display part 6 displays, for example, position information of the tip of the bonding head 2 and information such as the process window and measurement pattern.

FIG. 3 is a flow chart showing a heater temperature adjustment method (hereinafter also referred to as "this adjustment method") according to an exemplary embodiment. In this adjustment method, an example is shown in which one or more temperature control patterns associated with the bonding conditions for bonding the electronic component 9 to the substrate 8 are stored in the storage part 5. As shown in FIG. 3, this adjustment method includes a step st11 of controlling the temperature of the heater, a step st12 of generating a measurement pattern, a step st13 of determining whether the measurement pattern falls within the process window, a step st14 of generating a temperature control pattern, and a step st15 of storing the temperature control pattern. By repeatedly performing this adjustment method multiple times, a plurality of temperature control patterns associated with a plurality of types of pressure tools are generated. The processing in each step may be performed by the bonding apparatus 1 shown in FIG. 1. The following describes, as an example, a case where this adjustment method is performed by the bonding apparatus 1 shown in FIG. 1. Nevertheless, the type of the pressure tool is an example of the bonding conditions, and the bonding conditions include the types of chips and substrates that constitute the electronic components, differences in configuration from other apparatuses, differences in adhesive and solder for bonding the chips and substrates, differences in bonding conditions for bonding the chips and substrates, etc.

### <Bonding apparatus when adjusting the heater temperature>

### (Step st11: control the temperature of the heater)

In step st11, the temperature controller 42 controls the temperature of the heater 22, and heats or dissipates heat from the adjustment tool AT attached to the heater 22.

In step st11, the temperature controller 42 in FIG. 1 performs temperature control on the heater 22. The temperature control of the heater 22 may, for example, be performed so that the temperature increases or decreases according to an input operation of the user through the input part 3.

### (Step st12: generate the measurement pattern)

In step st12, the temperature measurement part 43 generates the measurement pattern from a change over time of the temperature obtained from the adjustment tool AT.

In step st12, the temperature measurement part 43 in FIG. 1 generates the measurement pattern as a feedback value obtained from the adjustment tool AT by the temperature controller 42 controlling the temperature of the heater 22. The measurement pattern is generated, for example, in the temperature measurement part 43 by dividing the change over time of the temperature obtained from the adjustment tool AT into a predetermined time.

### (Step st13: determine whether the measurement pattern falls within the process window)

In step st13, the temperature controller 42 determines whether the measurement pattern falls within the process window. That is, the temperature controller 42 acquires the process window associated with the type of the electronic component 9 from the storage part 5, and determines whether the measurement pattern acquired from the temperature measurement part 43 falls within the process window. In the case where the measurement pattern does not fall within the process window, the processing may be performed again from step st11. Step st11 to step st13 may be repeated multiple times until the measurement pattern falls within the process window. In the case where the measurement pattern falls within the process window, the processing proceeds to step st14.

In step st13, the temperature controller 42 in FIG. 1 acquires the process window associated with the type of the electronic component 9 from the storage part 5, and determines whether the measurement pattern acquired from the temperature measurement part 43 falls within the process window. The determination of whether the measurement pattern falls within the process window may be displayed on the display part 6. For example, in the case where at least a part of the measurement pattern does not fall within the temperature range of the process window, the user may input input information that brings the at least a part of the measurement pattern within the temperature range of the process window through the input part 3, and perform the processing again from step st11. In the case where common temperature control can be applied, a common process window may correspond to a plurality of types of electronic components 9.

### (Step st14: generate the temperature control pattern)

In step st14, the temperature controller 42 generates the temperature control pattern based on the measurement pattern that falls within the process window. That is, in the temperature controller 42, the temperature control pattern associated with the type of the electronic component 9 is generated. In the case where the temperature control pattern is generated using a common process window for a plurality of types of electronic components 9, a common temperature control pattern may be generated for the plurality of types of electronic components 9.

### (Step st15: store the temperature control pattern)

In step st15, the temperature control pattern generated by the temperature controller 42 is stored in the storage part 5. The temperature control pattern is generated in association with the type of the electronic component 9, and is stored in the storage part 6 in association with identification information for specifying the type of the pressure tool PT, which will be described later. A common temperature control pattern may be associated with a plurality of types of pressure tools PT.

From the above steps st11 to st15, the temperature control pattern associated with the type of the electronic component 9 is generated and stored in the storage part 5 in association with the pressure tool PT. This processing method described above is repeated multiple times, and the temperature control patterns respectively associated with a plurality of types of electronic components 9 are stored in advance in the storage part 5, to proceed to perform the bonding.

FIG. 4 is a flow chart showing the bonding according to an exemplary embodiment. An example is shown in which the controller 4 reads out one of the one or more temperature control patterns stored in the storage part 5 according to the bonding conditions, and performs bonding. As shown in FIG. 4, the bonding includes a step st21 of determining the type of the pressure tool, a step st22 of reading out the temperature control pattern, and a step st23 of performing bonding. The bonding is performed by selecting one of the one or more temperature control patterns generated by this adjustment method. The processing in each step may be performed by the bonding apparatus 1 shown in FIG. 2. The following describes, as an example, a case where the bonding is performed by the bonding apparatus 1 shown in FIG. 2. Nevertheless, the type of the pressure tool is an example of the bonding conditions, and the bonding conditions include the types of chips and substrates that constitute the electronic components, differences in configuration from other apparatuses, differences in adhesive and solder for bonding the chips and substrates, and differences in bonding conditions for bonding the chips and substrates.

### <Bonding apparatus when bonding is performed>

### (Step st21: determine the type of the pressure tool)

In step st21, the temperature controller 42 determines the type of the pressure tool PT. Since the pressure tool PT is associated with the type of the electronic component 9, the temperature control or pressure control suitable for the electronic component 9 to be mounted can be determined by determining the type of the pressure tool PT. In this case, the type of the pressure tool PT may be determined by the controller 4 acquiring the identification information of the pressure tool PT, or the type of the pressure tool PT attached to the bonding head 2 may be determined by the user visually checking the type of the electronic component 9 or pressure rule PT and inputting the same as the input information of the input part 3.

### (Step st22: read out the temperature control pattern)

In step st22, the temperature controller 42 reads out the temperature control pattern from the storage part 5. Specifically, the temperature controller 42 reads out one temperature control pattern associated with the pressure tool PT, from the one or more temperature control patterns associated with each type of pressure tool PT.

### (Step st23: perform bonding)

In step st23, the controller 4 controls the bonding head 2 to perform bonding.

Specifically, in step st23, the temperature controller 42 in FIG. 2 outputs the temperature control pattern read out from the storage part 5 to the heater 22 to perform temperature control. The temperature controller 42 may control the temperature of the heater 22 according to the pressure applied along with the upward and downward movement of the bonding head 2, and may, for example, perform temperature control by outputting the temperature control pattern from the temperature controller 42 so as to synchronize with the drive controller 41 driving the bonding head 2.

In addition, step st23 is performed in a state where the electronic component 9 is placed on the main surface of the substrate 8 disposed on the stage 7.

In step st23, the drive controller 41 in FIG. 2 drives the bonding head 2 to move downward until the electronic component 9 is pressed against the substrate 8, and performs pressurization and heating on the bonding head 2 for a predetermined time while the electronic component 9 is pressed against the substrate 8. At this time, for example, pressurization and heating are performed for a predetermined time while the bonding head 2 is pressing the electronic component 9 against the substrate 8, thereby melting the solder or the like provided on the electronic component 9 and joining the substrate 8 and the electronic component 9.

Through the above steps st21 to st23, one or more temperature control patterns associated with the pressure tool PT are read out from the storage part 5, and bonding is performed by the bonding apparatus 1.

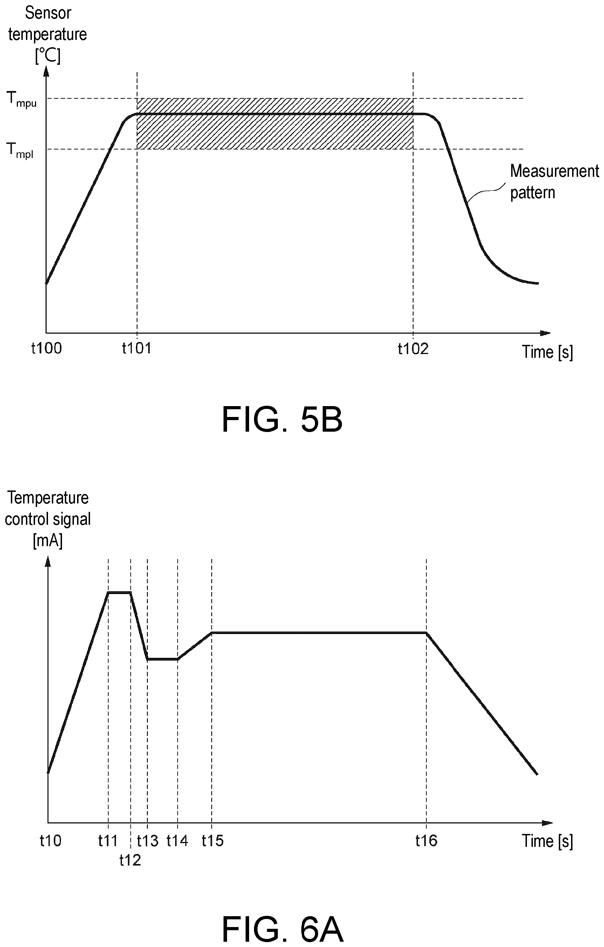

FIG. 5A is a diagram showing the temperature control signal output to the heater according to an exemplary embodiment. Further, FIG. 5B is a diagram showing an example of comparison between the process window and the measurement pattern according to an exemplary embodiment. The temperature control signal, measurement pattern, and process window shown in FIG. 5A and FIG. 5B may be respectively generated in the bonding apparatus 1 shown in FIG. 1. Below, the operation of the bonding apparatus 1 in this adjustment method and each waveform will be described with reference to FIG. 1 and FIG. 3. The temperature control signal refers to a control waveform for the temperature controller 42 to control the temperature of the heater 22, and may be generated based on the information input from the input part 3, for example.

FIG. 5A is the temperature control signal generated by the temperature controller 42 in step st11. As shown in FIG. 5A, the temperature control signal increases at a constant increase rate in times t10 to t11, goes through a constant current holding period in times t11 to t12, increases again at a constant increase rate in times t12 to t13, maintains a constant current value in times t13 to t14, and decreases at a constant decrease rate from time t14 onward.

The temperature control signal shown in FIG. 5A is generated by the temperature controller 42 and supplied to the heater 22. The temperature control signal shown in FIG. 5A may be generated by the temperature controller 42 based on the information input through the input part 3, for example.

FIG. 5B is an example of comparison in which whether the measurement pattern generated in step st12 falls within the process window is being determined in step st13. As shown in FIG. 5B, the measurement pattern falls within the process window. That is, the measurement pattern falls between the lower limit threshold temperature Tmpl and the upper limit threshold temperature Tmpu during the period of times t101 to t102.

The comparison between the measurement pattern and the process window shown in FIG. 5B may be performed by the temperature controller 42. In the comparison between the measurement pattern and the process window shown in FIG. 5B, for example, a feedback value obtained by inputting the temperature control signal in FIG. 5A to the heater 22 may be generated as the measurement pattern in the temperature measurement part 43, and the result of comparison with the process window acquired from the storage part 5 may be displayed on the display part 6.

Based on the measurement pattern shown in FIG. 5B, the temperature control pattern is generated by the temperature controller 42 in step st14, and is stored in the storage part 5 in step st15.

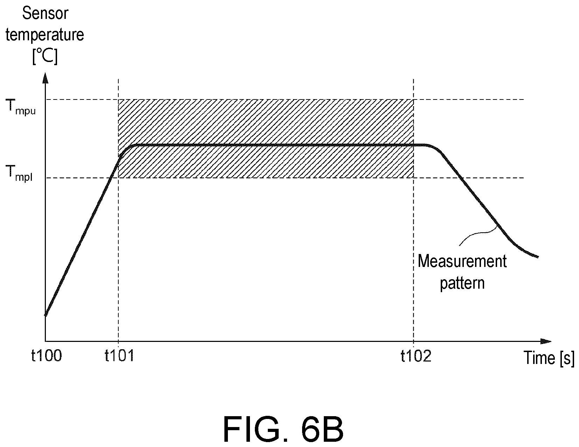

FIG. 6A is a diagram showing the temperature control signal output to the heater according to another exemplary embodiment. Further, FIG. 6B is a diagram showing an example of comparison between the process window and the measurement pattern according to another exemplary embodiment. The temperature control signal, measurement pattern, and process window shown in FIG. 6A and FIG. 6B may be respectively generated in the bonding apparatus 1 shown in FIG. 1. Below, the operation of the bonding apparatus 1 in this adjustment method and each waveform will be described with reference to FIG. 1 and FIG. 3.

FIG. 6A is the temperature control signal generated by the temperature controller 42 in step st11. As shown in FIG. 6A, the temperature control signal increases at a constant increase rate in times t10 to t11, goes through a constant current holding period in times t11 to t12, decreases again at a constant decrease rate in times t12 to t13, goes through a constant current holding period in times t13 to t14, increases at a constant increase rate in times t14 to t15, maintains a constant current value in times t15 to t16, and decreases at a constant decrease rate from time t16 onward.

The temperature control signal shown in FIG. 6A is generated by the temperature controller 42 and supplied to the heater 22. The temperature control signal shown in FIG. 6A may be generated by the temperature controller 42 based on the information input through the input part 3, for example.

FIG. 6B is an example of comparison in which whether the measurement pattern generated in step st12 falls within the process window is being determined in step st13. As shown in FIG. 6B, the measurement pattern falls within the process window. That is, the measurement pattern falls between the lower limit threshold temperature Tmpl and the upper limit threshold temperature Tmpu during the period of times t101 to t102.

The comparison between the measurement pattern and the process window shown in FIG. 6B may be performed by the temperature controller 42. In the comparison between the measurement pattern and the process window shown in FIG. 6B, for example, a feedback value obtained by inputting the temperature control signal in FIG. 6A to the heater 22 may be generated as the measurement pattern in the temperature measurement part 43, and the result of comparison with the process window acquired from the storage part 5 may be displayed on the display part 6.

Based on the measurement pattern shown in FIG. 6B, the temperature control pattern is generated by the temperature controller 42 in step st14, and is stored in the storage part 5 in step st15.

As described above, in this adjustment method, as shown in FIG. 5A and FIG. 5B, it is possible to bring the measurement pattern generated based on the temperature control signal within the process window. That is, by providing the constant current holding period in times t11 to t12 for the temperature control signal in FIG. 5A, the measurement pattern in FIG. 5B can fall within the process window without exceeding the upper limit threshold temperature Tmpu at the rising edge.

Moreover, as shown in FIG. 6A and FIG. 6B, in this adjustment method, it is possible to bring the measurement pattern generated based on the temperature control signal within the process window. That is, by providing the constant current holding period in times t11 to t12 for the temperature control signal in FIG. 6A, the measurement pattern in FIG. 6B does not exceed the upper limit threshold temperature Tmpu at the rising edge, and by providing the constant current holding period in times t13 to t14, the measurement pattern in FIG. 6B can fall within the process window without falling below the lower limit threshold temperature Tmpl at the rising edge.

FIG. 5A and FIG. 5B, and FIG. 6A and FIG. 6B are examples of waveforms to which this adjustment method is applied, respectively assuming different types of electronic components 9. That is, FIG. 5A and FIG. 5B, and FIG. 6A and FIG. 6B each have a different temperature control signal and a different process window. This adjustment method is not limited to these waveforms.

### <Another example of this embodiment>

Various modifications can be made to the embodiments of the present disclosure without departing from the scope and spirit of the present disclosure. For example, in this embodiment, the bonding head 2 is controlled using the common controller 4 during heater temperature adjustment and during bonding, but the bonding head may be controlled using different controllers. That is, when this adjustment method is applied, the controller may adjust the temperature of the heater using a tester having only the functions of the temperature controller 42 and the temperature measurement part 43.

In addition, for example, pressure patterns respectively associated with a plurality of types of electronic components 9 may be stored in the storage part 5, and when bonding is performed, the drive controller 41 may acquire the pressure pattern associated with the type of the electronic component 9 from the storage part 5 to drive the bonding head 2.

Further, for example, in this adjustment method, the temperature is adjusted by heating of the heater 22, but the temperature of the heater 22 may be adjusted by actually preparing the electronic component 9 and the substrate 8 and bonding these. For example, the bonding head 2 may be driven based on various control information input through the input part 3 to bond the electronic component 9 and the substrate 8, and the user may visually check how the electronic component 9 and the substrate 8 are joined and correct the input information of the input part 3, thereby controlling the temperature of the heater 22.

Furthermore, for example, in this adjustment method, the temperature controller 42 respectively acquires the process window from the storage part 5 and the measurement pattern from the temperature measurement part 43 to generate the temperature control pattern, but the temperature controller 42 may acquire the process window and the measurement pattern from the storage part 5 to generate the temperature control pattern. For example, the temperature measurement part 43 may generate a plurality of measurement patterns and store the plurality of measurement patterns in the storage part 5, and the temperature controller 42 may acquire the plurality of measurement patterns and one selected from a plurality of process windows from the storage part 5, and generate the temperature control pattern.

### Reference Signs List

1...bonding apparatus, 2...bonding head, 21...actuator, 22.. heater, 3...input part, 4...controller, 41...control driver, 42...temperature controller, 43... temperature measurement part, 5... storage part, 6...display part, 7...stage, 8...substrate, 9...electronic component, AT...adjustment tool, PT..pressure tool

## Claims

1. A bonding apparatus for bonding an electronic component to a substrate, the bonding apparatus comprising:
a bonding head comprising a pressure tool that pressurizes the electronic component and a heater that heats the pressure tool, wherein the pressure tool is configured to be attachable to and detachable from the heater;
a storage part storing temperature control data that indicates a temporal change in a set temperature of the heater; and
a controller controlling the set temperature of the heater based on the temperature control data,
wherein the temperature control data has one or more temperature control patterns associated with bonding conditions for bonding the electronic component to the substrate, and
the controller reads out one temperature control pattern of the one or more temperature control patterns according to the bonding conditions, and controls the set temperature of the heater.

2. The bonding apparatus according to claim 1, further comprising:
an adjustment tool being interchangeable with the pressure tool and configured to be attachable to and detachable from the heater; and
a temperature sensor measuring a temperature of the adjustment tool,
wherein the temperature control pattern is generated based on a measurement pattern that indicates a temporal change in a measured value from the temperature sensor when the controller controls the set temperature of the heater.

3. The bonding apparatus according to claim 2, wherein the storage part stores the measurement pattern in association with the temperature control pattern.

4. The bonding apparatus according to claim 2, wherein the measurement pattern has temperature characteristics in a range that falls within a process window when bonding the electronic component to the substrate.

5. The bonding apparatus according to claim 1, wherein the bonding conditions comprise a type of the pressure tool, and
one temperature control pattern of the one or more temperature control patterns is read out according to the type of the pressure tool to control the set temperature of the heater.

6. The bonding apparatus according to any one of claims 1 to 5, wherein the electronic component is a semiconductor chip having a bump-forming surface that has a plurality of bumps, and
the pressure tool pressurizes the electronic component in a direction in which the bump-forming surface of the semiconductor chip faces the substrate.

7. A bonding method, comprising:
preparing a bonding head comprising a pressure tool that pressurizes an electronic component and a heater that heats the pressure tool, wherein the pressure tool is configured to be attachable to and detachable from the heater;
pressurizing the electronic component toward a substrate with the pressure tool; and
reading out temperature control data that indicates a temporal change in a set temperature of the heater from a storage part, and controlling the set temperature of the heater based on the temperature control data by a controller,
wherein the temperature control data has one or more temperature control patterns associated with bonding conditions for bonding the electronic component to the substrate, and
controlling the set temperature of the heater comprises reading out one temperature control pattern of the one or more temperature control patterns according to the bonding conditions, and controlling the set temperature of the heater.

8. The bonding method according to claim 7, further comprising generating the temperature control pattern,
wherein generating the temperature control pattern comprises:
attaching an adjustment tool that is interchangeable with the pressure tool to the heater;
measuring a temperature of the adjustment tool attached to the heater by a temperature sensor;
acquiring a measurement pattern that indicates a temporal change in a measured value from the temperature sensor by the controller controlling the set temperature of the heater; and
generating the temperature control pattern based on the measurement pattern.

9. A bonding control program for controlling a bonding apparatus which comprises:
a bonding head comprising a pressure tool that pressurizes an electronic component and a heater that heats the pressure tool, wherein the pressure tool is configured to be attachable to and detachable from the heater;
a storage part storing temperature control data that indicates a temporal change in a set temperature of the heater; and
a controller controlling the set temperature of the heater based on the temperature control data,
wherein the temperature control data has one or more temperature control patterns associated with bonding conditions for bonding the electronic component to the substrate, and
the bonding control program causing a computer of the controller to:
read out one temperature control pattern of the one or more temperature control patterns according to the bonding conditions; and
control the set temperature of the heater based on the read temperature control pattern.

## Amended claims

### Amended claims under Art. 19.1 PCT

1. A bonding apparatus for bonding an electronic component to a substrate, the bonding apparatus comprising:
a bonding head comprising a pressure tool that pressurizes the electronic component and a heater that heats the pressure tool, wherein the pressure tool is configured to be attachable to and detachable from the heater;
a storage part storing temperature control data that indicates a temporal change in a set temperature of the heater;
a controller controlling the set temperature of the heater based on the temperature control data;
an adjustment tool being interchangeable with the pressure tool and configured to be attachable to and detachable from the heater; and
a temperature sensor measuring a temperature of the adjustment tool,
wherein the temperature control data has one or more temperature control patterns associated with bonding conditions for bonding the electronic component to the substrate, and
the controller reads out one temperature control pattern of the one or more temperature control patterns according to the bonding conditions, and controls the set temperature of the heater, and
the temperature control pattern is generated based on a measurement pattern that indicates a temporal change in a measured value from the temperature sensor when the controller controls the set temperature of the heater.

2. The bonding apparatus according to claim 1, wherein the storage part stores the measurement pattern in association with the temperature control pattern.

3. The bonding apparatus according to claim 1, wherein the measurement pattern has temperature characteristics in a range that falls within a process window when bonding the electronic component to the substrate.

4. The bonding apparatus according to claim 1, wherein the bonding conditions comprise a type of the pressure tool, and
one temperature control pattern of the one or more temperature control patterns is read out according to the type of the pressure tool to control the set temperature of the heater.

5. The bonding apparatus according to any one of claims 1 to 4, wherein the electronic component is a semiconductor chip having a bump-forming surface that has a plurality of bumps, and
the pressure tool pressurizes the electronic component in a direction in which the bump-forming surface of the semiconductor chip faces the substrate.

6. A bonding method, comprising:
preparing a bonding head comprising a pressure tool that pressurizes an electronic component and a heater that heats the pressure tool, wherein the pressure tool is configured to be attachable to and detachable from the heater;
pressurizing the electronic component toward a substrate with the pressure tool;
reading out temperature control data that indicates a temporal change in a set temperature of the heater from a storage part, and controlling the set temperature of the heater based on the temperature control data by a controller; and
generating a temperature control pattern,
wherein the temperature control data has one or more temperature control patterns associated with bonding conditions for bonding the electronic component to the substrate, and
controlling the set temperature of the heater comprises reading out one temperature control pattern of the one or more temperature control patterns according to the bonding conditions, and controlling the set temperature of the heater, and
generating the temperature control pattern comprises:
attaching an adjustment tool that is interchangeable with the pressure tool to the heater;
measuring a temperature of the adjustment tool attached to the heater by a temperature sensor;
acquiring a measurement pattern that indicates a temporal change in a measured value from the temperature sensor by the controller controlling the set temperature of the heater; and
generating the temperature control pattern based on the measurement pattern.

7. A bonding control program for controlling a bonding apparatus which comprises:
a bonding head comprising a pressure tool that pressurizes an electronic component and a heater that heats the pressure tool, wherein the pressure tool is configured to be attachable to and detachable from the heater;
a storage part storing temperature control data that indicates a temporal change in a set temperature of the heater;
a controller controlling the set temperature of the heater based on the temperature control data;
an adjustment tool being interchangeable with the pressure tool and configured to be attachable to and detachable from the heater; and
a temperature sensor measuring a temperature of the adjustment tool,
wherein the temperature control data has one or more temperature control patterns associated with bonding conditions for bonding the electronic component to the substrate, and
the bonding control program causing a computer of the controller to:
read out one temperature control pattern of the one or more temperature control patterns according to the bonding conditions;
control the set temperature of the heater based on the read temperature control pattern; and the temperature control pattern is generated based on a measurement pattern that indicates a temporal change in a measured value from the temperature sensor when the controller controls the set temperature of the heater.
